# EUROPEAN PATENT SPECIFICATION

(11) **EP 1 564 762 B1**
(45) Date of publication and mention of the grant of the patent: **09.05.2012**
(21) Application number: 05100872.0
(22) Date of filing: 09.02.2005
(51) Int. Cl.: H01F 37/00, H01F 27/10

(54) **Liquid-cooled choke**
Flüssigkeitsgekühlte Drosselspule
Bobine de self refroidie par liquide

(30) Priority: 13.02.2004 FI 20040230
(43) Date of publication of application: 17.08.2005
(73) Proprietor: ABB Oy, 00380 Helsinki (FI)
(72) Inventor: Helosvuori, Juhani, 01620, Vantaa (FI); Talja, Markku, 04400, Järvenpää (FI)
(74) Representative: Savolainen, Seppo Kalevi

(56) References cited:
- DE-A1- 3 522 740
- DE-A1- 3 843 807
- GB-A- 732 841
- US-A- 2 547 045
- US-A- 5 682 292

## Description

### BACKGROUND OF THE INVENTION

The invention relates to a liquid-cooled choke comprising a choke core, a choke coil and a path for a cooling liquid to cool the choke wherein the choke core is divided into at least two parts arranged in a cooling profile to which the path for the cooling liquid is arranged and which at the same time provides the choke with a frame and an assembly jig.

Heat losses occur both in the choke core and the choke coil. This heat should be transferred efficiently to the cooling liquid so that the choke would not be heated too much but would remain in the optimal operating temperature range defined for it.

US Patent 1790906 discloses a known solution where a two-piece coil is encapsulated such that a cooling liquid is circulated between the adjacent coils and on their edges in water channels arranged in the middle and ends of the encapsulation. Considering the basic structure of the choke, the implementation is relatively complex, and only the coil will be cooled in this way.

Another, newer arrangement is disclosed, for instance, in EP Patent 459326 where cooling liquid channels are arranged between different layers of the coil in the cast-resin body of the coil. Also this structure is very difficult to implement and it does not take the cooling demand of the core into account.
Further, an example of a liquid-cooled choke, where the choke core is divided into several parts, as described above, is disclosed in US Patent 5682292.

Typical of the former structures is that the cooling is in one way or another implemented in connection with the coil. These implementations also make the assembly and structure of the choke difficult and complex.

### SUMMARY OF THE INVENTION

It is an object of the present invention to provide a choke, by which the above-mentioned drawbacks can be eliminated and heat losses of the core and coil can be efficiently transferred to a cooling liquid.

This object is achieved by a choke of the invention, which is defined in the characterising portions of claims 1, 2 and 4.

In a first implementation of the invention the choke core is formed of two plate packs and the cooling profile comprises recesses for the plate packs on two opposing sides of the profile, whereby the cooling profile extends in between the plate packs and from there to two sides of each plate pack, and around the sides of the cooling profile covering the plate packs and the two bare sides of the plate packs there is an insulation and on top of the insulation there is the choke coil.

In a second implementation of the invention the choke core is formed of three plate packs, and the cooling profile comprises on its edges or circumference recesses for the plate packs at regular intervals, the plate packs being symmetrically arranged with respect to the central axis of the cooling profile, whereby the cooling profile extends into the middle of the plate packs and from there to two sides of each plate pack, and around the profile parts between the plate packs and the bare sides of each plate pack there is an insulation and on top of the insulation there is the choke coil. This solution enables a more efficient cooling both for the core and the coil. Furthermore, the plate packs can be shortened and, if desired, three chokes can be arranged in the same cooling profile column by only insulating the core plate packs from each other, which saves material and space.

In a third implementation of the invention the choke core is formed of three columns and the cooling profile comprises three openings on the same circular arch at regular intervals, into which the columns are positioned, the surfaces of the columns being lined with an insulation and a coil arranged on top of the insulation. Here, three separate chokes are in a way connected to the same cooling body of the invention to form one choke unit. If chokes are used, for instance, in the branches of an IGBT module, three three-column chokes are needed for one converter. Correspondingly, nine "one-column" chokes according to the first implementation are needed.

In each implementation, the path of the cooling liquid to the cooling profile is preferably arranged symmetrically in the middle of the choke core parts, the material of the cooling profile being preferably aluminium or a mixture thereof. If required, at desired points the cooling profile can be provided with additional cooling channels according to cooling power demand.

### LIST OF FIGURES

The invention will now be described by means of three preferred embodiments with reference to the attached drawings, in which
Figure 1 is a cross section of a first embodiment of the invention;
Figure 2 is a cross section of a second embodiment of the invention;
Figure 3 shows a choke column employing chokes of Figure 2; and
Figure 4 is a cross section of a third embodiment of the invention.

### DETAILED DESCRIPTION OF THE INVENTION

The output of an inverter typically comprises an output choke as a part of the filter to limit du/dt, i.e. change of voltage (u) with respect to time (t), and common mode currents, which further cause bearing currents and insulation load on the motor. The choke is a yoke-free type of choke.

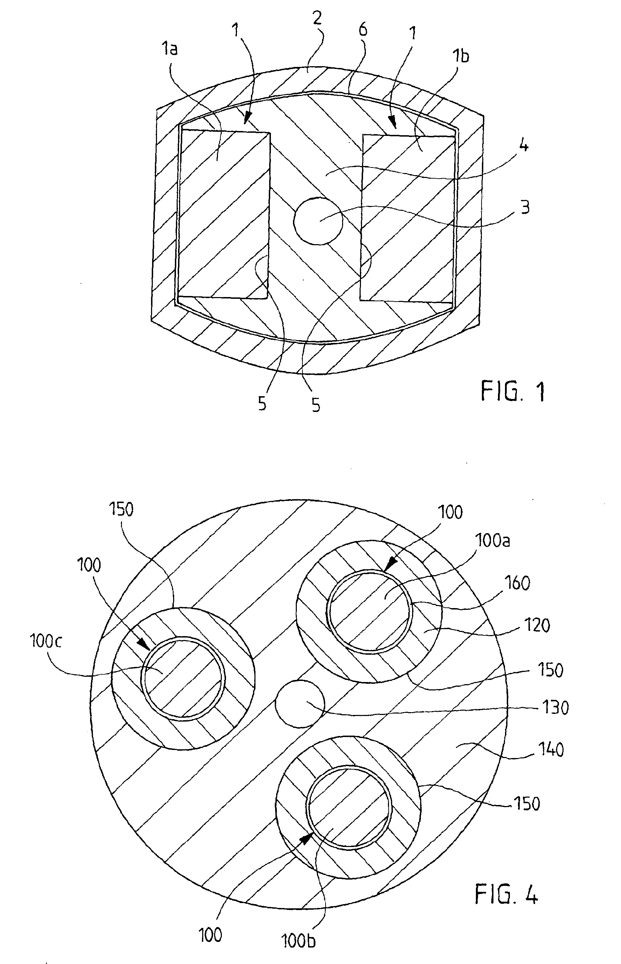

Figure 1 shows a "one-column" liquid-cooled choke of the invention, comprising a choke core 1, a choke coil 2 and a path 3 for a cooling liquid to cool the choke.

The choke core is divided into two parts 1a and 1b arranged in a cooling profile 4 to which the path 3 for the cooling liquid is arranged and which at the same time provides the choke with a frame and an assembly jig, as will be described in the following.

The divided choke core 1 is formed of two identical iron plate packs 1a and 1b, for which the cooling profile 4 comprises accurately dimensioned recesses 5 on its two opposing sides. When assembling the choke, the plates of the plate packs 1a and 1b are piled into the recesses 5 so that the cooling profile 4 extends in between the plate packs 1a and 1b and from there to two sides of each plate pack 1a and 1b, having a tight contact with the plate packs 1a and 1b. Then, an insulation 6 is wrapped around the sides of the cooling profile 4 covering these plate or core packs 1a and 1b and around the two bare sides, i.e. sides not covered with the cooling profile 4, of the core packs 1a and 1b, and the choke coil 2 made of profiled copper is coiled on top of the insulation. Finally, the packet thus formed is insulated and lacquered.

The path for the cooling liquid is here a channel 3 bored into the cooling profile 4 or formed in the extrusion phase, passing through the cooling profile 4 in the middle of the core packs 1a and 1b. Only two connections, input and output, are needed to circulate the cooling liquid. In this way, the core packs 1a and 1b are cooled effectively, and since the majority of the coil 2 is on top of the cooling profile 4, the effective cooling of the coil 2 is also secured. The material of the cooling profile 4 is preferably aluminium or a suitable mixture thereof.

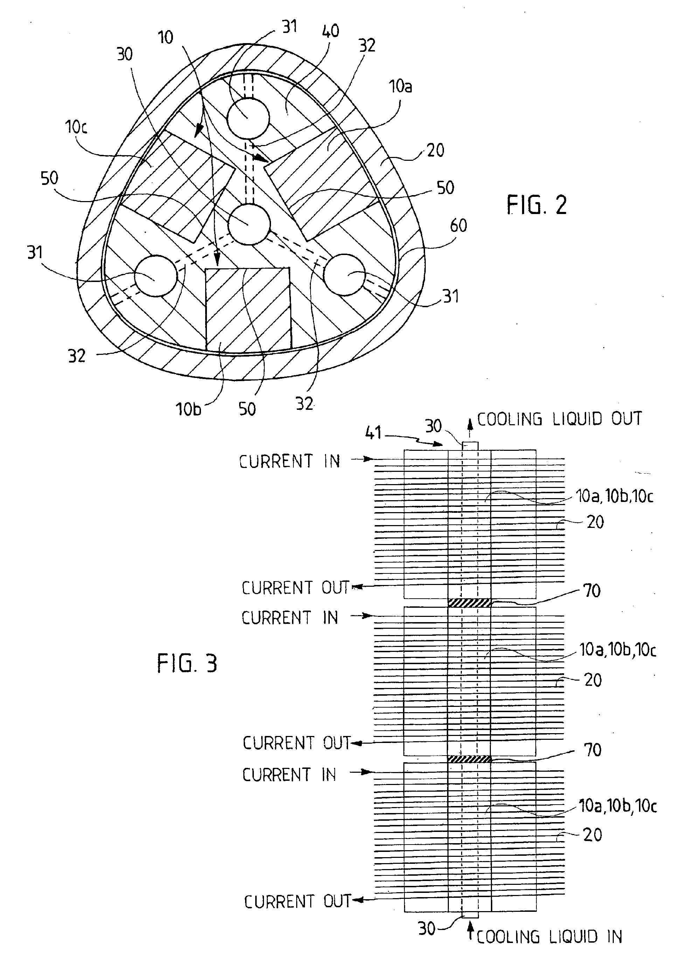

The choke shown in Figure 2 differs from the structure of Figure 1 primarily in that the choke core 10 is formed of three plate packs 10a, 10b and 10c. The cooling profile 40 comprises on its edges or circumference at regular intervals recesses 50 for the plate packs 10a, 10b and 10c, which are formed as in Figure 1. The plate packs 10a, 10b and 10c are arranged symmetrically with respect to the central axis of the cooling profile 40, and the cooling profile 40 extends into the middle of the plate pacts 10a, 10b and 10c and from there to two sides of each plate pack. Like in Figure 1, an insulation 60 is arranged around the profile parts between the plate packs 10a, 10b and 10c and around the bare side of each plate pack 10a, 10b and 10c and a choke coil 20 is arranged on top of the insulation. Also here, a path 30 for a cooling liquid is a channel 30 bored into the cooling profile 40 or formed in the extrusion phase, passing through the cooling profile 40 in the middle of the plate packs 10a, 10b and 10c. In addition, the figure shows feasible additional cooling channels 31, which may be located between each two core packs, for instance. These channels 31 can be connected to the main channel 30 by means of connecting channels 32. The cross section of the cooling profile 40 is preferably an intermediate form between a triangle and a circle, where no sharp angles are present and the coiling is easy to implement.

The solution of Figure 2 enables a more efficient cooling for both the core plate packs 10a, 10b and 10c and the coil 20, as was already stated in the beginning. In addition, the plate packs 10a, 10b and 10c can be shortened and, if desired, three different chokes can be arranged according to Figure 3 in the same cooling profile column 41 by only insulating the plate packs 10a, 10b and 10c of the chokes from each other by means of insulations 70. Measurements have shown that crosstalk takes place so that the current of the middlemost, also hottest, branch of the IGBT module decreases suitably. Crosstalk can be controlled by changing the distance of the coils 20.

Compared to the prior art, the choke provided with the cooling profiles 4 and 40 not only eliminates problems associated with cooling but also prevents the twisting of the iron core pack in conventional chokes, while the coil is coiled around it. It is, namely, difficult to coil thick profiled copper around the plate pack provided only with corner supports in such a manner that the pack will not be twisted.

Compromises with respect to the cross-sectional surface of the coil 2 and 20 (i.e. the copper layer) can be made with an efficient cooling. The reduction of the cross-sectional surface increases resistance, which is, up to a certain extent, useful in the yoke-free output choke of the inverter.

Figure 4 shows a third implementation of the choke of the invention. A choke core 100 is formed of three columns 100a, 100b and 100c, and a cooling profile 140 comprises three openings 150 on the same circular arch at regular intervals, into which the columns are positioned, the surfaces of the columns being lined with an insulation 160 and a coil 120 arranged on top of the insulation. Here, three separate chokes are in a way connected to the same cooling body of the invention to form one choke unit, as was already stated in the beginning.

Also here, the path for the cooling liquid is arranged in the cooling profile as a channel 130 extending in the middle of the choke core parts, as was the case also in Figures 1 and 2, and the cooling profile is preferably made of aluminium or an aluminium mixture.

The above specification is only intended to illustrate the basic idea of the invention. However, a person skilled in the art can modify the details of the invention within the scope of the attached claims.

## Claims

1. A liquid-cooled choke comprising a choke core (1), a choke coil (2) and a path (3) for a cooling liquid to cool the choke, wherein the choke core (1) is divided into at least two parts (1 a, 1 b) arranged in a cooling profile (4) to which the path (3) for the cooling liquid is arranged and which at the same time provides the choke with a frame and an assembly jig, **characterized in that** the choke core (1) is formed of two plate packs (1a, 1 b) and the cooling profile (4) comprises recesses (5) for the plate packs on two opposing sides of the profile, whereby the cooling profile (4) extends in between the plate packs (1a, 1 b) and from there to two sides of each plate pack, and that around the sides of the cooling profile (4) covering the plate packs (1a, 1b) and the two bare sides of the plate packs there is an insulation (6) and on top of the insulation there is the choke coil (2).

2. A liquid-cooled choke comprising a choke core (10), a choke coil (20) and a path (30) for a cooling liquid to cool the choke, wherein the choke core (10) is divided into at least two parts (10a, 10b, 10c) arranged in a cooling profile (40) to which the path (30) for the cooling liquid is arranged and which at the same time provides the choke with a frame and an assembly jig, **characterized in that** the choke core (10) is formed of three plate packs (10a, 10b, 10c) and the cooling profile (40) comprises on its edges or circumference recesses (50) for the plate packs at regular intervals, the plate packs (10a, 10b, 10c) being symmetrically arranged with respect to the central axis of the cooling profile (40), whereby the cooling profile extends into the middle of the plate packs and from there to two sides of each plate pack, and that around the profile parts between the plate packs (10a, 10b, 10c) and the bare sides of each plate pack there is an insulation (60) and on top of the insulation there is the choke coil (20)

3. A choke as claimed in claim 2, **characterized in that** three separate chokes are arranged in the same cooling profile column (41), whereby the plate packs (10a, 10b, 10c) of the chokes on top of each other are insulated from each other by means of protection insulations (70).

4. A liquid-cooled choke comprising a choke core (100), a choke coil (120) and a path (130) for a cooling liquid to cool the choke, wherein the choke core (100) is divided into at least two parts (100a, 100b, 100c) arranged in a cooling profile (140) to which the path (130) for the cooling liquid is arranged and which at the same time provides the choke with a frame and an assembly jig, **characterized in that** the choke core (100) is formed of three columns (100a, 100b, 100c) and the cooling profile (140) comprises three openings (150) on the same circular arch at regular intervals, into which the columns (100a, 100b, 100c) are positioned, the surfaces of the columns being lined with an insulation (160) and a coil (120) arranged on top of the insulation.

5. A choke as claimed in any one of the preceding claims, **characterized in that** the path (3; 30; 130) for the cooling liquid is arranged in the cooling profile in the middle of the parts of the choke core (1a, 1b; 10a, 10b, 10c; 100a, 100b, 100c).

6. A choke as claimed in any one of the preceding claims, **char** - **acterized** in that the cooling profile (40) is provided with additional cooling channels (31) at desired points.

7. A choke as claimed in any one of the preceding claims, **characterized in that** the cooling profile (4; 40; 140) is made of aluminium or an aluminium mixture.

## Patentansprüche

1. Eine flüssigkeitsgekühlte Drosselspule, die einen Drosselspulenkern (1), eine Drosselspulenspirale (2) und einen Pfad (3) für eine Kühlflüssigkeit zur Kühlung der Drosselspule aufweist, wobei der Drosselspulenkern (1) in mindestens zwei Teile (1 a, 1b) aufgeteilt ist, die in einem Kühlprofil (4) angeordnet sind, zu dem der Pfad (3) für die Kühlflüssigkeit angeordnet ist und das gleichzeitig die Drosselspule mit einem Rahmen und einem Montagejig versieht, **dadurch gekennzeichnet, dass** der Drosselspulenkern (1) aus zwei Plattengruppen (1 a, 1b) geformt ist und dass das Kühlprofil (4) Ausnehmungen (5) für die Plattengruppen auf zwei sich gegenüberliegenden Seiten des Profils aufweist, wobei das Kühlprofil (4) sich zwischen die Plattengruppen (1 a, 1 b) und von dort aus auf zwei Seiten einer jeden Plattengruppe erstreckt, und dass um den Seiten des Kühlprofils (4) herum, das die Plattengruppen (1a, 1 b) abdeckt, und den zwei baren Seiten der Plattengruppen eine Isolation (6) vorhanden ist und dass sich oben auf der Isolation die Drosselspulenspirale (2) befindet.

2. Eine flüssigkeitsgekühlte Drosselspule mit einem Drosselspulenkern (10), einer Drosselspulenspirale (20) und einem Pfad (30) für die Kühlflüssigkeit zur Kühlung der Drosselspule, wobei der Drosselspulenkern (10) in mindestens zwei Teile (10a, 10b, 10c) aufgeteilt ist, die in einem Kühlprofil (40) angeordnet sind, zu dem der Pfad (30) für die Kühlflüssigkeit angeordnet ist und das gleichzeitig die Drosselspule mit einem Rahmen und einem Montagejig versieht, **dadurch gekennzeichnet, dass** der Drosselspulenkern (10) aus drei Plattengruppen (10a, 10b, 10c) gebildet ist und das Kühlprofil (40) an seinen Rändern oder an seinem Kreisumfang Ausnehmungen (50) für die Plattengruppen in regelmäßigen Abständen aufweist, wobei die Plattengruppen (10a, 10b, 10c) symmetrisch bezüglich der zentralen Achse des Kühlprofils (40) angeordnet sind, wobei das Kühlprofil sich in die Mitte der Plattengruppen und von dort auf zwei Seiten einer jeden Plattengruppe erstreckt, und dass um den Profilteilen herum zwischen den Plattengruppen (10a, 10b, 10c) und den baren Seiten einer jeder Plattengruppe eine Isolation (60) vorhanden ist und dass die Drosselspulenspirale (20) sich oben auf der Isolation befindet.

3. Eine Drosselspule gemäß dem Anspruch 2, **dadurch gekennzeichnet, dass** drei separate Drosselspulen in derselben Kühlprofilsäule (41) angeordnet sind, wobei die aufeinander befindlichen Plattengruppen (10a, 10b, 10c) der Drosselspulen voneinander durch Schutzisolationen (70) isoliert sind.

4. Eine flüssigkeitsgekühlte Drosselspule mit einem Drosselspulenkern (100), einer Drosselspulenspirale (120) und einem Pfad (130) für eine Kühlflüssigkeit zur Kühlung der Drosselspule aufweist, wobei der Drosselspulenkern (100) in mindestens zwei Teile (100a, 100b, 100c) aufgeteilt ist, die in einem Kühlprofil (140) angeordnet sind, zu dem der Pfad (130) für die Kühlflüssigkeit angeordnet ist und das gleichzeitig die Drosselspule mit einem Rahmen und einem Montagejig versieht, **dadurch gekennzeichnet, dass** der Drosselspulenkern (100) aus drei Säulen (100a, 100b, 100c) gebildet ist und das Kühlprofil (140) drei Öffnungen (150) auf demselben kreisförmigen Bogen in regelmäßigen Abständen aufweist, in die die Säulen (100a, 100b, 100c) positioniert sind, wobei die Oberfläche der Säulen mit einer Isolation (160) bezogen sind und eine Spirale (120) oben auf der Isolation angeordnet ist.

5. Eine Drosselspule gemäß einem der vorangehenden Patentansprüche, **dadurch gekennzeichnet, dass** der Pfad (3; 30; 130) für die Kühlflüssigkeit in das Kühlprofil in die Mitte der Teile des Drosselspulenkerns (1 a, 1b; 10a, 10b, 10c; 100a, 100b, 100c) angeordnet ist.

6. Eine Drosselspule gemäß einem der vorangehenden Patentansprüche, **dadurch gekennzeichnet, dass** das Kühlprofil (40) mit zusätzlichen Kühlkanälen (31) an gewünschten Stellen versehen ist.

7. Eine Drosselspule gemäß einem der vorangehenden Patentansprüche, **dadurch gekennzeichnet, dass** das Kühlprofil (4; 40; 140) aus Aluminium oder einer Aluminiumlegierung hergestellt ist.

## Revendications

1. Bobine d'arrêt à refroidissement liquide, comprenant un noyau de bobine (1), un enroulement de bobine (2) et un chemin (3) destiné à ce qu'un liquide de refroidissement refroidisse la bobine d'arrêt, dans laquelle le noyau de bobine (1) est divisé en au moins deux parties (la, 1b) agencées en un profil de refroidissement (4) auquel est adapté le chemin (3) pour le liquide de refroidissement et qui fournit en même temps à la bobine d'arrêt une armature et un montage d'assemblage, **caractérisée en ce que** le noyau de bobine (1) est constitué de deux ensembles de plaques (1a, 1b) et le profil de refroidissement (4) comprend des évidements (5) destinés aux ensembles de plaques sur deux côtés opposés du profil, le profil de refroidissement (4) s'étendant entre les ensembles de plaques (1a, 1b) et de là vers deux côtés de chaque ensemble de plaques, et **en ce que**, autour des côtés du profil de refroidissement (4) qui couvre les ensembles de plaques (1a, 1b) et les deux côtés nus des ensembles de plaques, il y a une isolation (6) et par-dessus l'isolation, il y a l'enroulement de bobine (2).

2. Bobine d'arrêt à refroidissement liquide, comprenant un noyau de bobine (10), un enroulement de bobine (20) et un chemin (30) destiné à ce qu'un liquide de refroidissement refroidisse la bobine, dans laquelle le noyau de bobine (10) est divisé en au moins deux parties (10a, 10b, 10c) agencées en un profil de refroidissement (40) auquel est adapté le chemin (30) pour le liquide de refroidissement et qui fournit en même temps à la bobine une armature et un montage d'assemblage, **caractérisée en ce que** le noyau de bobine (10) est constitué de trois ensembles de plaques (10a, 10b, 10c) et le profil de refroidissement (40) comprend sur ses bords ou sur sa circonférence, des évidements (50) destinés aux ensembles de plaques et disposés à intervalles réguliers, les ensembles de plaques (10a, 10b, 10c) étant agencés de manière symétrique par rapport à l'axe central du profil de refroidissement (40), grâce à quoi le profil de refroidissement s'étend jusqu'au milieu des ensembles de plaques et de là vers deux côtés de chaque ensemble de plaques, et **en ce que**, autour des parties du profil entre les ensembles de plaques (10a, 10b, 10c) et les côtés nus de chaque ensemble de plaques, il y a une isolation (60) et par-dessus l'isolation, il y a l'enroulement de bobine (20).

3. Bobine d'arrêt selon la revendication 2, **caractérisée en ce que** trois bobines d'arrêt séparées sont agencées dans la même colonne de profil de refroidissement (41), les ensembles de plaques (10a, 10b, 10c) des bobines d'arrêt empilées les unes sur les autres étant isolés les uns des autres par des moyens d'isolations de protection (70).

4. Bobine d'arrêt à refroidissement liquide, comprenant un noyau de bobine (100), un enroulement de bobine (120) et un chemin (130) destiné à ce qu'un liquide de refroidissement refroidisse la bobine, dans laquelle le noyau de bobine (100) est divisé en au moins deux parties (100a, 100b, 100c) agencées en un profil de refroidissement (140) auquel est adapté le chemin (130) pour le liquide de refroidissement et qui fournit en même temps à la bobine une armature et un montage d'assemblage, **caractérisée en ce que** le noyau de bobine (100) est constitué de trois colonnes (100a, 100b, 100c) et le profil de refroidissement (140) comprend trois ouvertures (150) sur le même arc circulaire disposées à intervalles réguliers, dans lesquelles sont positionnées les colonnes (100a, 100b, 100c), les surfaces des colonnes étant revêtues d'une isolation (160) et un enroulement (120) étant agencé sur l'isolation.

5. Bobine d'arrêt selon l'une quelconque des revendications précédentes, **caractérisée en ce que** le chemin (3 ; 30 ; 130) pour le liquide de refroidissement est agencé dans le profil de refroidissement au milieu des parties du noyau de bobine (1a, 1b ; 10a, 10b, 10c ; 100a, 100b, 100c).

6. Bobine d'arrêt selon l'une quelconque des revendications précédentes, **caractérisée en ce que** le profil de refroidissement (40) est doté de canaux de refroidissement supplémentaires (31) situés en des points voulus.

7. Bobine d'arrêt selon l'une quelconque des revendications précédentes, **caractérisée en ce que** le profil de refroidissement (4 ; 40 ; 140) est réalisé en aluminium ou dans un mélange d' aluminium.
